# EUROPEAN PATENT APPLICATION

(11) **EP 4 848 934 A1**
(43) Date of publication of application: **02.12.2026**
(21) Application number: 25185562.3
(22) Date of filing: 26.06.2025
(51) Int. Cl.: H10D 30/47, H10D 62/10, H10D 62/17, H10D 62/85

(54) **HIGH-ELECTRON-MOBILITY TRANSISTORS WITH IMPROVED SHORT-CIRCUIT WITHSTAND CAPABILITY**

(30) Priority: 28.05.2025 US 202519220886
(71) Applicant: GlobalFoundries U.S. Inc., Malta, NY 12020 (US)
(72) Inventor: HEBERT, Francois, Santa Clara, CA, 95054 (US); BENTLEY, Steven John, Malta, NY, 12020 (US); KANTAROVSKY, Johnatan Avraham, Essex Junction, VT, 05452 (US)
(74) Representative: Lambacher, Michael

(57) **Abstract**

The present disclosure relates to semiconductor structures and, more particularly, to high-electron-mobility transistors and methods of manufacture. The structure includes: a gate structure (20) on a stack (18) of semiconductor materials; a source region (16) on a first side of the gate structure; a drain region (22) on a second side of the gate structure; an ohmic contact (14) connecting to the source region, on the first side of the gate structure; and a structure (12) in the source region which increases a resistance of the stack of semiconductor materials in the source region between the device and the ohmic contact.

## Description

### BACKGROUND

This invention was made with government support under contract number HQ0727790700 awarded by Defense Microelectronics Activity (DMEA). The government has certain rights in the invention.

The present disclosure relates to semiconductor structures and, more particularly, to high-electron-mobility transistors and methods of manufacture.

A high-electron-mobility transistor (HEMT) is a field-effect transistor incorporating a junction between two materials with different band gaps (i.e. a heterojunction) as the channel. HEMTs are able to operate at higher frequencies than Silicon or SiC transistors, e.g., up to 10Mhz instead of Kilohertz frequencies, and are used in high-frequency power products such cell phone and notebook computer chargers, bidirectional electric vehicle chargers, power switching, and electric motor drivers.

### SUMMARY

In an aspect of the disclosure, a structure comprises: a gate structure on a stack of semiconductor materials; a source region on a first side of the gate structure; a drain region on a second side of the gate structure; an ohmic contact connecting to the source region, on the first side of the gate structure; and a structure in the source region which increases a resistance of the stack of semiconductor materials in the source region between the gate structure and the ohmic contact.
According to one variant, the structure may comprise a plurality of isolation implant regions in the source region and within the stack of semiconductor material. The plurality of isolation implant regions may comprise crystalline defects within the stack of semiconductor material; the crystalline defects may be within a 2D Electron Gas (2DEG) channel layer of the stack of semiconductor materials.
Further, the plurality of isolation implant regions may electrically connect to the ohmic contact in the source region. Further, the plurality of isolation implant regions may physically contact the ohmic contact in the source region.
Further, the isolation implant regions may be shaped as polygons. Optionally, the isolation implant regions may be shaped as trapezoids.
Further, the drain region may be devoid of the isolation implant regions.
According to another variant, the structure may comprise a plurality of floating gate islands over the stack of semiconductor materials in the source region, adjacent to the gate structure. The plurality of floating gate islands may comprise P-GaN material.
According to still another variant, the structure may comprise a plurality of gate islands over the stack of semiconductor materials and in the source region, electrically connecting to the ohmic contact. Alternatively, the structure may comprise a plurality of gate islands over the stack of semiconductor materials in the source region, electrically connecting to a pad.

In an aspect of the disclosure, a structure comprises: a gate structure comprising a source region and a drain region; an ohmic contact connecting to the source region and to the drain region; and at least one high resistance island in the source region extending within an underlying stack of semiconductor materials.
The at least one high resistance island may extend within a 2D Electron Gas (2DEG) channel of the stack of semiconductor materials. Further, the at least one high resistance island may comprise a plurality of islands contacting to the ohmic contact of the source region.
According to one variant, the at least one high resistance island may comprise a defective crystalline structure of the underlying stack of semiconductor materials.
According to another variant, the at least one high resistance island may comprise a plurality of floating P-GaN islands. Alternatively, the at least one high resistance island may comprise a plurality of P-GaN islands hardwired to one of the ohmic contact of the source region and a pad.

In an aspect of the disclosure, a method comprises: forming a gate structure on a stack of semiconductor materials; forming an ohmic contact connecting to a source region, on the first side of the device; and forming an implant isolation structure in the source region.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1A shows a cross-sectional view and respective fabrication processes of a structure in accordance with aspects of the present disclosure.
FIG. 1B shows a top-down view of the structure of FIG. 1A.
FIG. 2 shows a top-down view of an alternative structure in accordance with aspects of the present invention.
FIG. 3 shows a top-down view of another alternative structure in accordance with aspects of the present invention.
FIG. 4A shows a cross-sectional view and respective fabrication processes of another structure in accordance with aspects of the present disclosure.
FIG. 4B shows a top-down view of the structure of FIG. 4A.
FIG. 5 shows a top-down view of a further alternative structure in accordance with aspects of the present invention.
FIG. 6 shows a top-down view of yet another structure in accordance with aspects of the present invention.

### DETAILED DESCRIPTION

The present disclosure relates to semiconductor structures and, more particularly, to high-electron-mobility transistors and methods of manufacture. More specifically, the present disclosure relates to high-electron-mobility transistors (HEMTs) with source ballasting to limit the current during short-circuit conditions. In embodiments, the source ballasting may include an isolation implant region in the source region of a semiconductor substrate or, alternatively, formation of a gate electrode island on the semiconductor substrate in the source region. In embodiments, the source ballasting provides longer short-circuit withstand time for reliable performance, e.g., for inverters of an electric motor.

As should be understood by those of skill in the art, power devices need to withstand short-circuits for a period long enough for gate drivers and various other control circuits to react in time to shut down the power devices before any permanent damage can occur. Conventional enhancement-mode (normally-off) GaN power devices, for example, may suffer from a short short-circuit withstand time (SCWT). This may impact the adoption of GaN for high-volume electrical motor inverter applications.

The HEMTs described herein, though, are designed to maximize the short-circuit withstand time using source ballasting, without significantly impacting the Rdson*Area and cost. The source ballasting will not significantly impact the Rdson*Area under normal operating conditions since the gate-source resistance is a minor component of the total Rdson. However, under short-circuit conditions when the current far exceeds normal operating conditions at high voltage, the high current flowing through the source ballasting will create a voltage drop which reduces the gate voltage. For example, with a nominal source-drain current of 100A, the total source resistance with ballasting may account for less than 10% of the device on resistance (Rdson), while under short-circuit conditions, the Ids can jump to 500-1000A, resulting in a source-gate voltage drop of approximately 1V to 2V, hence reducing the voltage at the gate electrode, reducing dissipated power during short circuits, and hence increasing short-circuit withstand times.

Advantageously, the present disclosure provides many advantages including, amongst others, lower cost. Also, the devices described herein do not require additional process steps and are compatible with GaN HEMT power devices including, e.g., E-mode devices, D-mode devices, insulated gate devices, P-GaN gate devices, Gate Injection Transistor (GIT) devices, etc.

The structures of the present disclosure can be manufactured in a number of ways using a number of different tools. In general, though, the methodologies and tools are used to form structures with dimensions in the micrometer and nanometer scale. The methodologies, i.e., technologies, employed to manufacture the structures of the present disclosure have been adopted from integrated circuit (IC) technology. For example, the structures are built on wafers and are realized in films of material patterned by photolithographic processes on the top of a wafer. In particular, the fabrication of the structures uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

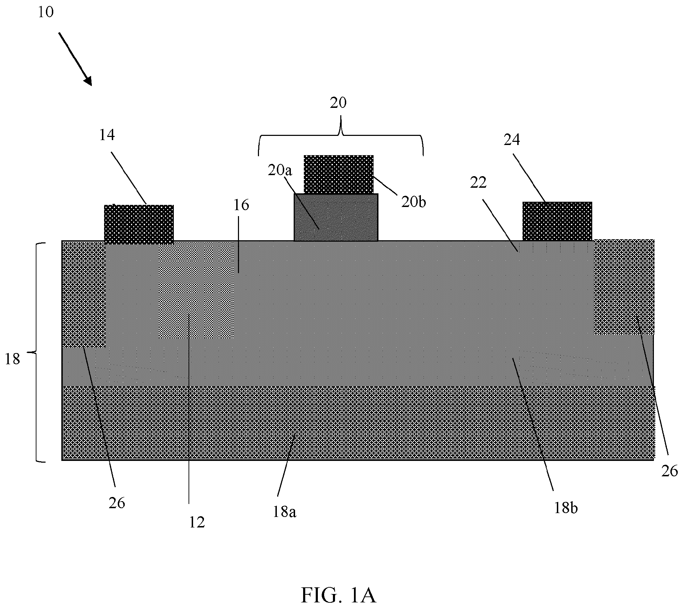

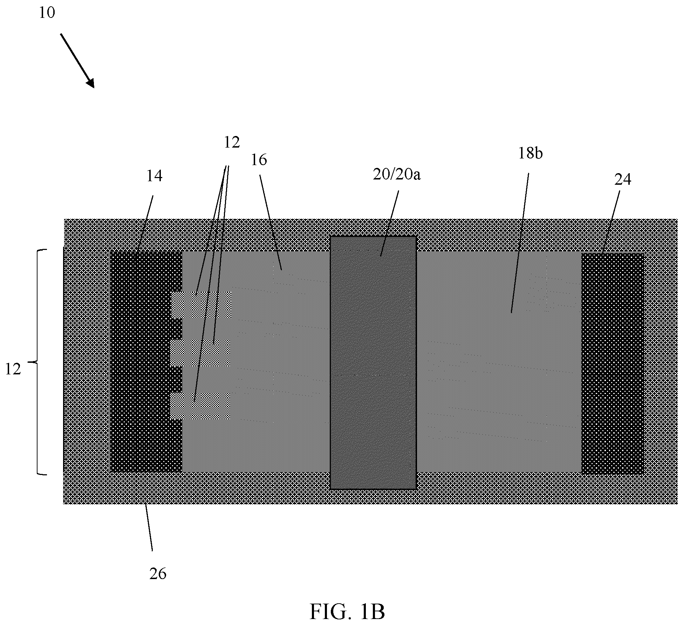

FIG. 1A shows a cross-sectional view and respective fabrication processes of a structure in accordance with aspects of the present disclosure, and FIG. 1B shows a top-down view of the structure of FIG. 1A. The structure 10 comprises isolation implant regions 12, e.g., damaged regions by the implantation, which eliminates the 2DEG low resistance region within the implanted region, in a source region 16, adjacent to and connecting to an ohmic contacts within the source region 16. The isolation implant regions 12 may be created by a nitrogen implant, for example, which is used to create defects (e.g., disordering of the single crystalline structure) in the underlying semiconductor substrate 18, which ensure low-leakage isolation between devices, e.g., P-GaN HEMT devices. It should be understood that the gate structures 20 shown in FIG. 1A as P-GaN structures may alternatively be metal gate structures for D-mode devices. Also, it should be understood that the implanted region can isolate the entire transistor including the gate structure and relate source region 16 and drain region 22.

In FIGS. 1A and 1B, the semiconductor substrate 18 may include, for example, an underlying semiconductor substrate 18a comprising single crystalline Si material with a (111) orientation; although other crystalline orientations are contemplated herein (e.g., a (100), (110), or (001) crystallographic orientations). A stack of semiconductor materials 18b may be provided over the underlying semiconductor substrate 18a. The stack of semiconductor materials 18b may be, for example, a III-N stack of semiconductor materials such as gallium nitride (GaN) or aluminum gallium nitride (AlGaN), among others, formed on underlying semiconductor substrate 18a; although other materials are also contemplated by the present disclosure.

By way of an illustrative, non-limiting example, the stack of semiconductor material 18b may include a nucleation layer, e.g., AlN, formed on the underlying semiconductor substrate 18a with one or more buffer layers between the AlN layer and GaN semiconductor material. As should be understood by those of skill in the art, the nucleation layer helps avoid melt-back etching of Ga into Si, as well as reduces the interlayer diffusion of impurities into the channel layer. The buffer layers may be step graded, interlayer and superlattice layer(s) comprising one or more layers of AlGaN, with the composition of Al gradually decreasing from a bottom layer to a top layer. A GaN layer may be formed on an uppermost layer of AlGaN material. The GaN layer may act as a channel layer, with a 2D Electron Gas (2DEG) channel formed below the AlGaN material. A 2D Electron Gas (2DEG) channel is a conducting region where electrons are free to move in two dimensions but are confined to a narrow region in the third. This confinement creates a 2D sheet of electrons that can be used as a conducting channel in various electronic devices. The different semiconductor layers may be formed by an epitaxial growth process as is known in the art, typically by metal organic CVD (MOCVD). It should be recognized by those of skill in the art that the present disclosure is not limited to a GaN stack and, in embodiments, may include other transistors comprising different III-V materials such as GaAs and AlGaAs (as a substitute for GaN and AlGaN), or other III-V compounds.

Still referring to FIG. 1, the stack of semiconductor materials 18b includes a source region 16 and a drain region 22, on opposing sides of a gate structure 20. The source region 16 and the drain region 22 both include ohmic contacts 14, 24 formed on sides of the gate structure 20. The gate structure 20 may include GaN material 20a, epitaxially grown on the stack of semiconductor material 18b. In more specific embodiments, the GaN material 20a may be P-type GaN material (P-GaN) epitaxially grown on the stack of semiconductor material 18b with an in-situ doping process as is known in the art. The P-GaN enables a normally-off enhancement-mode device operation, which is preferable for most power applications. A conductive gate electrode material 20b may be deposited and patterned over the P-GaN material. It should be understood that the P-GaN gate structure may include multiple layers of semiconductor, only some of which may be p-doped. For example, there may be layers with different doping, or, for example, regions of AlGaN or InGaN as part of the P-GaN structure.

In embodiments, the source and drain ohmic contacts 14, 24 may be formed on the stack of semiconductor materials 18b with different conductive material as the gate structure 20. The conductive material of the source/drain contacts 14, 24 may include, for example, aluminum or other conductive materials. In embodiments, current flows between the source and drain contacts 14, 24, with the gate structure 20 controlling the current flow between the source region 16 and drain region 22, e.g., ohmic contacts 14, 24. The gate structure 20 and the source/drain contacts 14, 24 can be formed by separate conventional lithography, etching and deposition methods known to those of skill in the art.

The source and drain contacts 14, 24 and the gate structure 20 of one transistor may be isolated from other structures including a different transistor, by an implant 26. The implantation processes may include using a patterned implantation mask to define selected areas exposed for the implantations. The implantation masks may include a layer of a light-sensitive material, such as an organic photoresist, applied by a spin coating process, pre-baked, exposed to light projected through a photomask, baked after exposure, and developed with a chemical developer. The implantation masks have a thickness and stopping power sufficient to block masked areas against receiving a dose of the implanted ions.

Still referring to FIGS. 1A and 1B, the isolation implant regions 12, e.g., damaged regions, may be provided within the source region 16, adjacent to and electrically connecting to the ohmic contact 14 of the source region 16. In this embodiment, the isolation implant regions 12, e.g., damaged regions, may be directly and physically in contact with the ohmic contact 14 of the source region 16. The drain region 22 is devoid of the isolation implant regions 12, e.g., damaged regions.

The isolation implant regions 12 may be provided by a nitrogen implant, for example. In alternate embodiments, the isolation implant regions 12 may be formed by other inert gases, e.g., argon, which can damage the underlying stack of semiconductor substrate 18b. As should be understood by those of skill in the art, the regions damaged by the inert gas can be used to control the conductivity of the stack of semiconductor materials 18b and, more specifically, of the 2D Electron Gas (2DEG) channel layer.

In any of the scenarios, the isolation implant regions 12 create defects (e.g., defects in the crystalline structure) in the stack of semiconductor substrate 18b and, more specifically, at least within the 2D Electron Gas (2DEG) channel of the stack of semiconductor substrate 18b. The defected region, e.g., damaged region, will effectively increase the resistance of the underlying stack of semiconductor substrate 18b which will disorder the crystal and reduce the 2D Electron Gas (2DEG) channel density as well as increasing resistance of the surrounding semiconductor layers of the stack of semiconductor substrate 18b. Accordingly, the isolation implant regions 12 will provide a restriction of current between the source region 16 and the gate structure 20, e.g., no current flows within the isolation implant regions 12 between the source region 16 and the gate structure 20, thus increasing resistance in the source region 16. As such, as is now understood by those of skill in the art, the isolation implant regions 12 increase the source resistance (Rs) and thereby increases short-circuit withstand time.

In this embodiment, the isolation implant regions 12 may comprise multiple (e.g., three) implant regions shaped as polygons and separated from one another and from the gate structure 20; although other shapes, sizes and distribution (e.g., amount of) of isolation implant regions 12 are contemplated herein. In embodiments, the spacing and shapes of the isolation implant regions 12 can vary, with the goal that the isolation implant regions 12 will not change the cell pitch in order to minimize the Rs or specific resistance of the device, defined as drain-source resistance times the area of the device, Rdson*Area. The isolation implant regions 12 may be formed using the same implant as regions 26, or they may have a different implant profile, energy or dose.

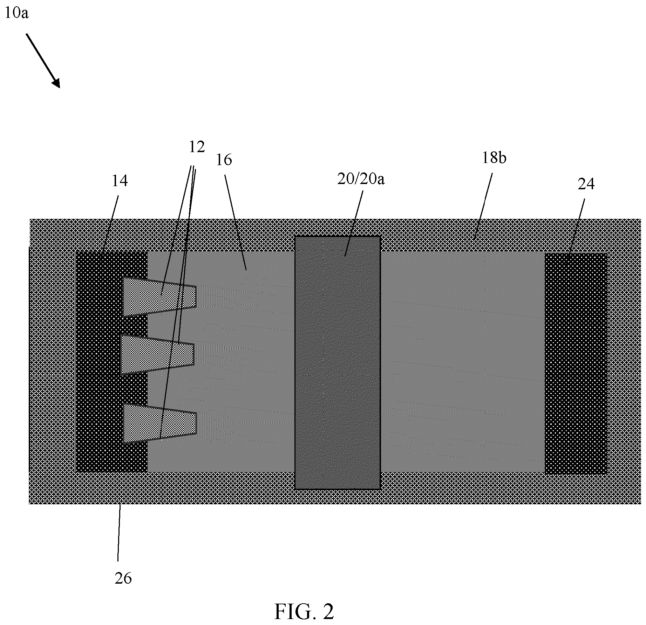

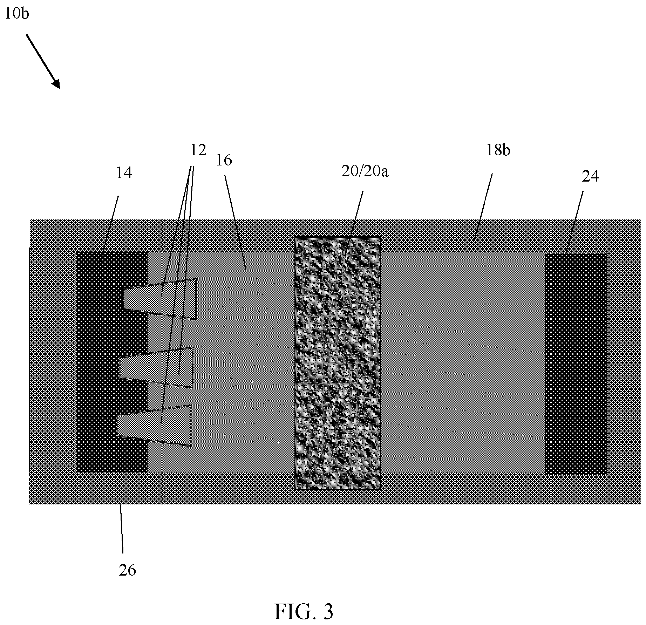

FIGS. 2 and 3 show a top-down view of alternative structures in accordance with aspects of the present invention. In FIG. 2, for example, the structure 10a shows the isolation implant regions 12 being trapezoidal in shape, with the narrower end facing the gate structure 20 and the wider end contacting the ohmic contact 14 of the source region 16. In FIG. 3, on the other hand, the structure 10b shows the isolation implant regions 12 being trapezoidal in shape, with the wider end facing the gate structure 20 and the narrower end contacting the ohmic contact 14 of the source region. In either of these configurations, the shape of the isolation implant regions 12 may be used to tune the resistance of the device and, hence, the short-circuit withstand time. For example, the different shapes and distribution of the isolation implant regions 12 can be used for current crowding to increase in resistance (Rs) as the current increases. The plurality of implanted regions in any of these configurations may not all have the same shapes; for example, their size, shape or distribution may vary across the width of the device.

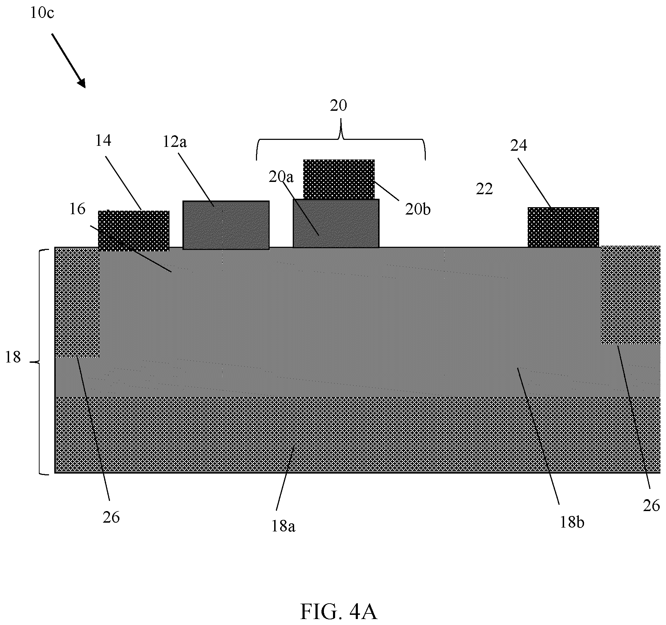

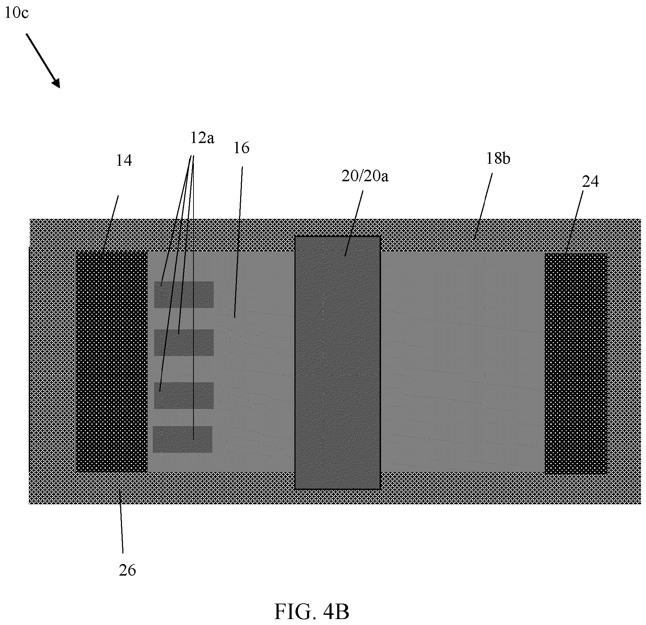

FIG. 4A shows a cross-sectional view and respective fabrication processes of another structure in accordance with aspects of the present disclosure. FIG. 4B shows a top-down view of the structure of FIG. 4A. In the structure 10d of FIGS. 4A and 4B, a plurality of islands 12a are formed on the stack of semiconductor materials 18b in the source region 16, e.g., adjacent to the ohmic contact 14 and the gate structure 20. In embodiments, the plurality of islands 12a may comprise GaN material and, more specifically, P-GaN material, e.g., same material used for the gate structure 20, for a preferred enhancement-mode HEMT device. An optional gate metal may be used with the GaN material 12a. The P-GaN material 12a will provide a local depletion of the 2D Electron Gas (2DEG) channel under the P-GaN gate islands formed in the source extension region. These P-GaN regions have the same composition as the P-GaN gate 20a.

In further embodiments, the plurality of islands 12a, e.g., GaN material, may be floating between the source region 16, e.g., ohmic contact 14, and the gate structure 20. That is, there is no electrical connections to the P-GaN islands 12a. As should be understood, the P-GaN islands 12a will provide local depletion of the 2DEG layers in these regions, effectively increasing the resistance of the underlying stack of semiconductor materials 18b.

Also, as described with respect to the implant isolation regions 12, the P-GaN islands 12a may be shaped as polygons, trapezoids or other shapes and in different distributions to further tune the resistance of the underlying stack of semiconductor substrate 18b, e.g., within the 2D Electron Gas (2DEG) channel. The plurality of P-GaN islands may not all have the same shapes; for example, their size, shape or distribution may vary across the device width. The remaining features are similar to the structures shown in FIGS. 1A and 1B such that no further explanation is required for a complete understanding of the present disclosure.

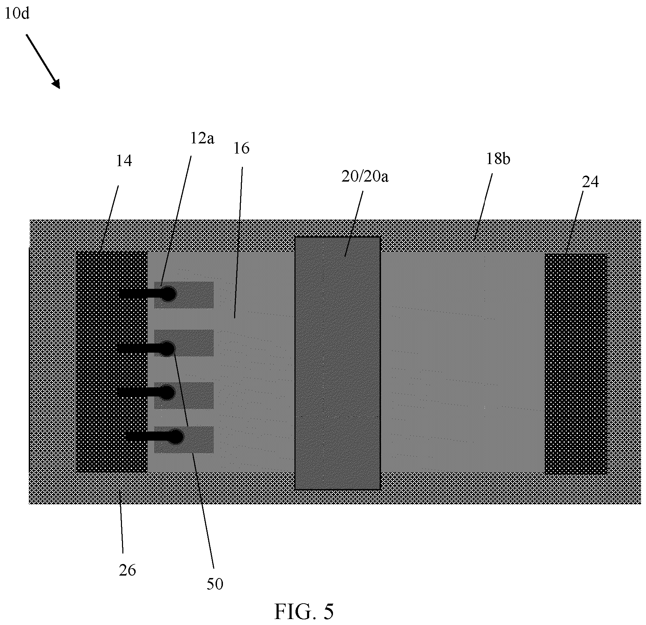

FIG. 5 shows a top-down view of an alternative structure 10d with each of the plurality of islands 12a in the source region 16 being separately, electrically connected to the source region 16, e.g., ohmic contact 14. The electrical connections 50, hardwired, to the source region 16, e.g., ohmic contact 14, of the islands 12a may force the local depletion of 2D Electron Gas (2DEG) channel layer under these plurality of islands 12a. This can be achieved simply by extending the Source Metal or a higher level metal (not shown) to connect the P-GaN islands formed in the source extension region. The remaining features are similar to the structures shown in FIGS. 4A and 4B such that no further explanation is required for a complete understanding of the present disclosure.

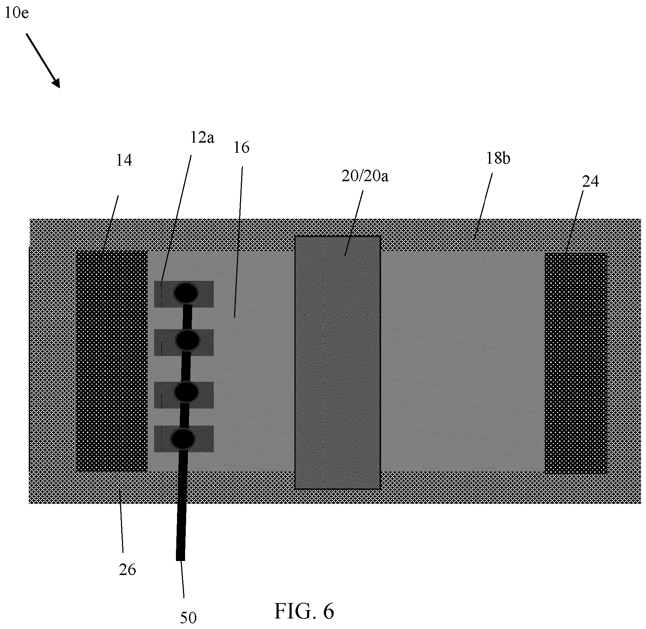

FIG. 6 shows a top-down view of an alternative structure 10e with each of the plurality of islands 12a in the source region 16 being electrically connected, e.g., hardwired, 50 in series to another pad. The electrical connection may force to deplete locally under these plurality of islands 12a. Further, as already noted herein, the plurality of islands 12a, e.g., P-GaN islands, may be dynamically biased on in on-state to reduce resistance, for example, by be connecting to other pads in series. It is also possible that the P-GaN islands could be connected to multiple pads, with some islands connected to one pad and others connected to another pad, or some may be connected to the source directly, allowing some islands to be biased differently from others. For example, in embodiments, it is contemplated that the plurality of islands 12a, e.g., P-GaN islands, may be dynamically biased on in on-state to reduce resistance, for example, may be connected to other pads rather than hardwired to the source region 16.The remaining features are similar to the structures shown in FIGS. 4A and 4B such that no further explanation is required for a complete understanding of the present disclosure.

The HEMT can be utilized as a single device in discrete applications, may be combined in a single package with several other devices of the same or varying types via co-packaging or multi-chip 3D integration techniques, or may be combined with several other devices in system on chip (SoC) technology. The SoC is an integrated circuit (also known as a "chip") that integrates all components of an electronic system on a single chip or substrate. As the components are integrated on a single substrate, SoCs consume much less power and take up much less area than multi-chip designs with equivalent functionality. Because of this, SoCs are becoming the dominant force in the mobile computing (such as in Smartphones) and edge computing markets. SoC is also used in embedded systems and the Internet of Things. Moreover, GaN devices are increasingly being employed in SoC designs where multiple GaN HEMTs are formed on a single substrate.

The method(s) as described above is used in the fabrication of discrete device chips or integrated circuit chips. The resulting chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a gate structure on a stack of semiconductor materials;
a source region on a first side of the gate structure;
a drain region on a second side of the gate structure;
an ohmic contact connecting to the source region, on the first side of the gate structure; and
a structure in the source region which increases a resistance of the stack of semiconductor materials in the source region between the gate structure and the ohmic contact.

2. The structure of claim 1, wherein the structure comprises a plurality of isolation implant regions in the source region and within the stack of semiconductor material.

3. The structure of claim 2, wherein the plurality of isolation implant regions comprise crystalline defects within the stack of semiconductor material, and, optionally, wherein the crystalline defects are within a 2D Electron Gas (2DEG) channel layer of the stack of semiconductor materials.

4. The structure of claim 2 or claim 3, wherein the plurality of isolation implant regions electrically connect to the ohmic contact in the source region.

5. The structure of one of claims 2 to 4, wherein the plurality of isolation implant regions physically contact the ohmic contact in the source region.

6. The structure of one of claims 2 to 5, wherein the drain region is devoid of the isolation implant regions.

7. The structure of one of claims 2 to 6, wherein the isolation implant regions are shaped as polygons, and, optionally, wherein the isolation implant regions are shaped as trapezoids.

8. The structure of claim 1, wherein the structure comprises a plurality of floating gate islands over the stack of semiconductor materials in the source region, adjacent to the gate structure, and, optionally, wherein the plurality of floating gate islands comprise P-GaN material.

9. The structure of claim 1, wherein the structure comprises a plurality of gate islands over the stack of semiconductor materials and in the source region, electrically connecting to the ohmic contact, or wherein the structure comprises a plurality of gate islands over the stack of semiconductor materials in the source region, electrically connecting to a pad.

10. A structure comprising:
a gate structure comprising a source region and a drain region;
an ohmic contact connecting to the source region and to the drain region; and
at least one high resistance island in the source region extending within an underlying stack of semiconductor materials.

11. The structure of claim 10, wherein the at least one high resistance island extends within a 2D Electron Gas (2DEG) channel of the stack of semiconductor materials.

12. The structure of claim 10 or claim 11, wherein the at least one high resistance island comprises a plurality of islands contacting to the ohmic contact of the source region.

13. The structure of one of claims 10 to 12, wherein the at least one high resistance island comprises a defective crystalline structure of the underlying stack of semiconductor materials.

14. The structure of one of claims 10 to 12, wherein the at least one high resistance island comprises a plurality of floating P-GaN islands, wherein the at least one high resistance island comprises a plurality of P-GaN islands hardwired to one of the ohmic contact of the source region and a pad.

15. A method comprising:
forming a gate structure on a stack of semiconductor materials;
forming an ohmic contact connecting to a source region, on the first side of the device; and
forming an implant isolation structure in the source region.
